Europäisches Patentamt

European Patent Office

Office européen des brevets

(11) Publication number: **0 283 953**
**A1**

# EUROPEAN PATENT APPLICATION

(21) Application number: 88104353.3

(22) Date of filing: 18.03.88

(51) Int. Cl.4: **H01L 21/31** , H01L 23/52 , H01L 21/90

(30) Priority: 23.03.87 JP 68253/87

(43) Date of publication of application:
28.09.88 Bulletin 88/39

(84) Designated Contracting States:
DE FR GB

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Abe, Masahiro c/o Patent Division**
**Kabushiki Kaisha Toshiba 1-1 Shibaura**
**1-chome**
**Minato-ku Tokyo 105(JP)**
Inventor: **Katsura, Toshihiko c/o Patent**
**Division**
**Kabushiki Kaisha Toshiba 1-1 Shibaura**
**1-chome**
**Minato-ku Tokyo 105(JP)**

(74) Representative: **Hansen, Bernd, Dr.rer.nat. et**
**al**
**Hoffmann, Eitle & Partner Patentanwälte**
**Arabellastrasse 4**
**D-8000 München 81(DE)**

(54) Method of forming aluminum wiring layer in semiconductor device.

(57) A method of forming an aluminum wiring in a semiconductor device is disclosed. According to this method, a thin film of aluminum or its alloy is deposited on a semiconductor substrate (S3). Then, a surface of the thin film is oxidized to form an oxide thin film (S5). After the two steps are repeatedly performed and a desired film thickness is obtained, the resultant film is patterned to a desired shape. Fine grain boundaries are vertically, as well as horizontally formed in the aluminum wiring formed in this method, thereby acquiring high degree of hardness. When resin-sealed products are fabricated, the disconnections caused by the pressure from the resin molding layer can be greatly decreased.

F I G. 2

## Method of forming aluminum wiring layer in semiconductor device

The present invention relates to a method of forming an aluminum wiring layer in a semiconductor device and, more particularly, to a method of increasing the strength of aluminum wirings.

Thin films of aluminum or aluminum alloys are the most commonly used wiring material for semiconductor devices (wirings made of these materials will be referred to as aluminum wirings hereinafter). This is because aluminum is excellent in workability, and has a comparatively small volume resistivity of 2.7 $\mu\Omega$ cm. Currently, an aluminum wiring having a film thickness of 0.8 to 3.0 $\mu$m and a line width of 1.0 to several ten $\mu$m is used in semiconductor ICS, whereas an aluminum wiring having a film thickness of 0.8 to several ten $\mu$m and a line width of 1.0 to several hundred $\mu$m is used in discrete semiconductor devices.

In the field of semiconductor devices, a packaging technique of sealing a semiconductor chip with a resin molding layer is widely employed. In such resin-sealed semiconductor devices, compression stress is laterally applied to its aluminum wirings because of shrinkage of the molded resin. The aluminum wirings are mechanically damaged by this stress. In the worst case, disconnections are caused, resulting in a critical failure.

Recently, as the packing density of a semiconductor device is increased, the chip size is also increased, and hence the stress applied onto the wirings is enhanced. In addition, with advances in the micro-patterning of aluminum wirings, they become increasingly susceptible to mechanical damages. For this reason, critical failures due to the disconnections have been increased.

In order to prevent the disconnections described above, a low-stress resin is used for sealing to attenuate and decrease the stress on wirings, a junction coating material is coated, or other similar methods are employed. According to still another method, the thickness of a passivation film for covering a wiring layer is increased so as to improve resistance to the stress. However, all these methods are not sufficiently effective, and may greatly increase the manufacturing cost.

A metallographic approach can be presented as a means for increasing the strength of aluminum wirings and preventing the disconnections. Generally, mechanical strength of a metal can be increased by decreasing the crystal size. For example, the hardness of steel is greatly enhanced by quenching because the crystal size is decreased and grain boundaries are formed in the longitudinal and lateral directions.

In the field of aluminum wiring, the following facts are known. When the pass length of particles is large in depositing aluminum, grains in the deposited aluminum film grow small, resulting in an increase in hardness. For the formation of such an aluminum layer, a method using a planetary deposition system is employed. According to this method, an aluminum target arranged in a bell jar is sputtered and evaporated using magnetron sputtering, and deposited on a wafer located on a rotary planet, which is arranged in the bell jar. In contrast to the above case, when the pass length of particles is small, grains in the deposited film grow large and the hardness is decreased. In recent magnetic sputtering method, a wafer is located close to oppose a cathode for sputtering.

However, the above-described facts have not yet applied to the prevention of disconnections of aluminum wirings. This is because, deposition of aluminum can be performed at a high rate using the magnetron sputtering, whereas the deposition rate using the planetary deposition system is too low to suitably process a large-diameter wafer. Therefore, if the hardness of aluminum wirings is increased by utilizing the planetary deposition system, the yield is inevitably dropped.

The present invention has been made in consideration of the above situation, and has as its object to provide a method of forming aluminum wirings having high resistance to mechanical damages and high reliability upon fabrication of semiconductor devices without greatly increasing the manufacturing cost.

More specifically, it is an object of the present invention to provide a method of forming an aluminum wiring having a miniaturized grain structure and high mechanical strength by utilizing conventional apparatuses.

It is another object of the present invention to allow the employment of magnetron sputtering having a high deposition rate as a method of depositing an aluminum film.

The above objects can be achieved by a method of forming a wiring in a semiconductor device, comprising the first step of depositing a thin film of aluminum or an aluminum alloy on a semiconductor substrate, and the second step of covering the thin film of aluminum or the aluminum alloy with an oxide film by oxidizing the surface of the thin film, wherein the first and second steps are continually repeated a plurality of times to obtain a desired film thickness, and then the resultant film is patterned in a desired shape.

This invention can be more fully understood from the following detailed description when taken in conjunction with the accompanying drawings, in which:

Fig. 1A is a sectional view illustrating a microstructure of an aluminum wiring formed by the present invention;

Fig. 1B is a sectional view illustrating a microstructure of an aluminum wiring formed by a conventional method;

Fig. 2 is a view of the steps according to an embodiment of the present invention;

Fig. 3 is a graph showing the characteristics of the aluminum wiring formed by the method according to the embodiment in Fig. 1; and

Fig. 4 is a graph showing a comparison between the results of thermal history tests of resin-sealed, packaged products of semiconductor devices, one of which is obtained by forming its wiring using the method of the embodiment in Fig. 2 and the other of which is obtained by forming its wiring using the conventional method.

The present invention is applied to a wiring made of aluminum, an alloy of aluminum and silicon, an alloy of aluminum and a high-melting or refractory metal (e.g., tungsten or molybdenum), and other alloy materials containing aluminum. The reason why the application range is limited to these wirings is that the problem of disconnections caused by the compression stress of the resin molding layer is especially noticeable in aluminum wirings made of aluminum or of aluminum alloys.

In the first step of the present invention, a method of depositing a thin film of aluminum or its alloy on a semiconductor substrate is not specifically limited, and a conventional method can be directly used. More specifically, either method; a planetary deposition system or a magnetron sputtering system can be employed. Therefore, it is preferable to use the magnetron sputtering method which has a higher deposition rate and is suitable for a process using large-diameter wafers.

In the second step of the present invention, for a method of oxidizing a surface of the thin film of aluminum or its alloy, any one of the following methods can be used, i.e., a method of locating the thin film in an atmosphere, a method of locating it in the atmosphere and heating it, a method of locating it in distilled water, or the like. When the thin film is to be heated, the heating temperature is preferably set at about 150°C. These methods are advantageous because they can be easily applied without difficulty.

In the present invention, a conventional photolithographic technique can be employed for patterning a wiring layer to a desired shape.

Miniaturized grain boundaries are formed in the following manner in an aluminum wiring formed by the above method of the present invention.

When a thin film of aluminum or its alloy is deposited on a semiconductor wafer, as the deposited film cools, grain boundaries which correspond to its film thickness are formed in a horizontal direction. The grain boundaries formed at this time are proportionally decreased or increased in size in relation to the thickness of the film. Since, in the present invention, a desired film thickness is obtained by repeating the step of depositing an aluminum thin film a plurality of times on the surface of the semiconductor substrate, the thickness of the thin film formed in one deposition step is relatively small. Therefore, the grain boundaries formed in the horizontal direction are greatly decreased in size compared with those of the conventional method.

In addition, according to the present invention, the deposition process of aluminum or its alloy is interrupted and a process is inserted, wherein a film of an oxide such as alumina ($Al_2O_3$) is formed by oxidizing a surface of the deposited film. Consequently, grain boundaries are vertically formed. More specifically, since the oxide film is interposed, continuity in the crystal structure is interrupted between the adjacent thin films despite the fact that a new thin film deposited on the oxide film is made of the same material as the aluminum or its alloy film previously formed. Therefore, the grain boundaries are formed in the vertical direction.

As a result, the aluminum wiring formed by the present invention has a microstructure, as shown in Fig. 1A. Referring to Fig. 1A, reference numeral 11 denotes a semiconductor substrate (e.g., silicon), in which various impurity regions which constitute an element such as a transistor are formed; 12, an insulating film such as a $SiO_2$ film; and 13, an aluminum wiring. As shown in Fig. 1A, wiring 13 has miniaturized grain boundaries in the horizontal and vertical directions. Note that as the number of surface treatments such as oxidation, are increased, the grain boundaries decrease in size.

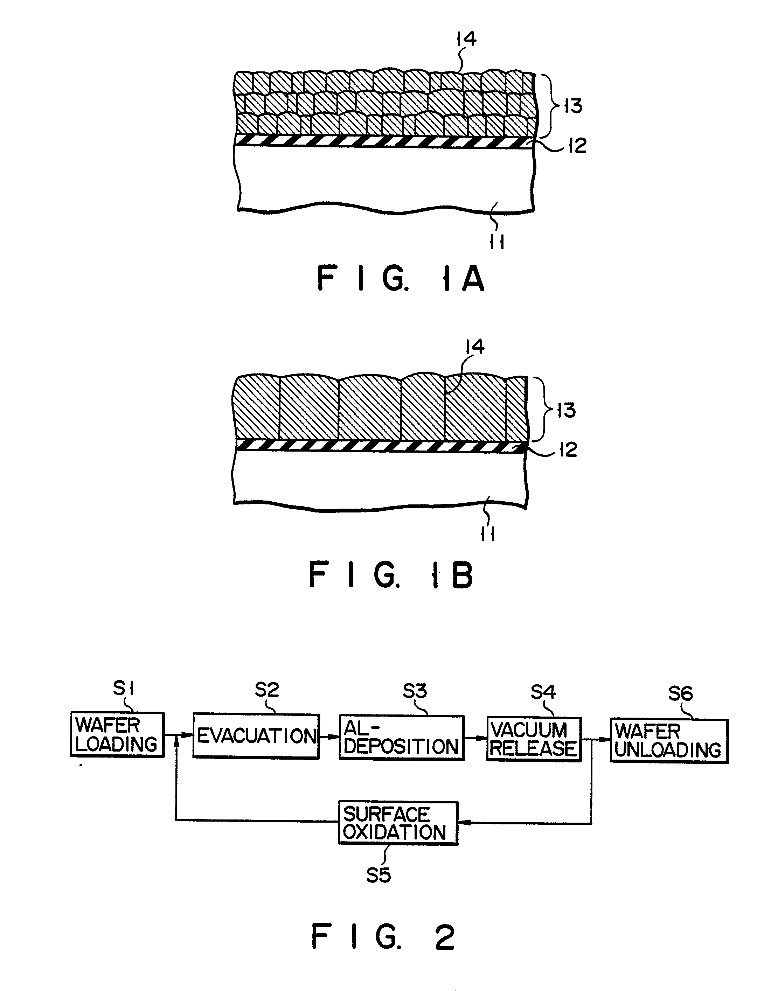

In contrast to the above case, in a conventional wiring made of aluminum or its alloy, i.e., a wiring formed in a single magnetron sputtering process, grain boundaries are formed only in the horizontal direction. In addition, each grain size is large. For this reason, the grain boundaries are formed in the state as shown in Fig. 1B.

It is apparent from the comparison between Figs. 1A and 1B that in the present invention, extremely fine grain boundaries are formed in an aluminum wiring, and hence its hardness can be enhanced. Therefore, the frequency at which disconnections occur in resin-sealed products can be greatly reduced. In addition, according to the present invention, since oxidation as an inexpensive method is employed, the increase in the manufacturing cost, as compared with the conventional method, is relatively small.

As is apparent from the above description, the oxidation process in the present invention aims to interrupt the continuity of an aluminum crystal structure at the boundary, located between the aluminum or its alloy thin films formed before and after the oxidation process. The following methods are equivalent to the oxidation in the present invention from this viewpoint.

A first method is of nitriding a surface of a thin film. More specifically, a method is employed, wherein the thin film is exposed in an atmosphere of an active nitrogen gas such as a nitrogen plasma.

A second method is of depositing any other metal such as beryllium on the thin film surface by means of sputtering. In this case, a metal is deposited on part of the thin film surface formed in the first step instead of on its entire surface, and for this reason, the process is called "nuclei-forming".

The present invention will be further described in detail with reference to the following Example.

Example

This example was performed along the flow chart in Fig. 2.

In step S1, a silicon wafer having an insulating film such as a silicon oxide film formed on its surface is placed in a vacuum chamber. In step S2, the vacuum chamber is evacuated prior to deposition of an aluminum film. In step S3, an aluminum is deposited on a surface of the wafer to a predetermined film thickness. In step S4, a vacuum is released in the vacuum chamber and atmospheric air is introduced thereinto. In step S5, an oxidizing atmosphere is maintained and surface oxidation of the aluminum thin film is performed. Subsequently, the process of steps S2 to S5 is repeated until a desired film thickness, suitable for a wiring, is obtained. When the desired film thickness is obtained, the flow advances to step S6, and the wafer is unloaded from the vacuum chamber.

In this example, the aluminum deposition of step S3 was performed by a wafer-opposing type DC magnetron sputtering. In this case, the temperature, the deposition rate, and the film thickness per every one process were set to be 250°C, 1.0 $\mu$m/min, and 0.33 $\mu$m, respectively. Note that 1.0 wt% of silicon is contained in the deposited aluminum thin film.

The surface oxidation in step S5 was performed by exposing the thin film to the air. The period of time in which the films were exposed to the air was altered, ranging within 1 to 30 minutes, and its influence upon the properties of the respective films finally obtained was checked. However, no significant changes were found. Therefore, the period of time for exposing a thin film to the air was set to be 1 minute. By this surface oxidation treatment, an alumina film having a thickness corresponding to several molecules was formed on a surface of the aluminum thin film.

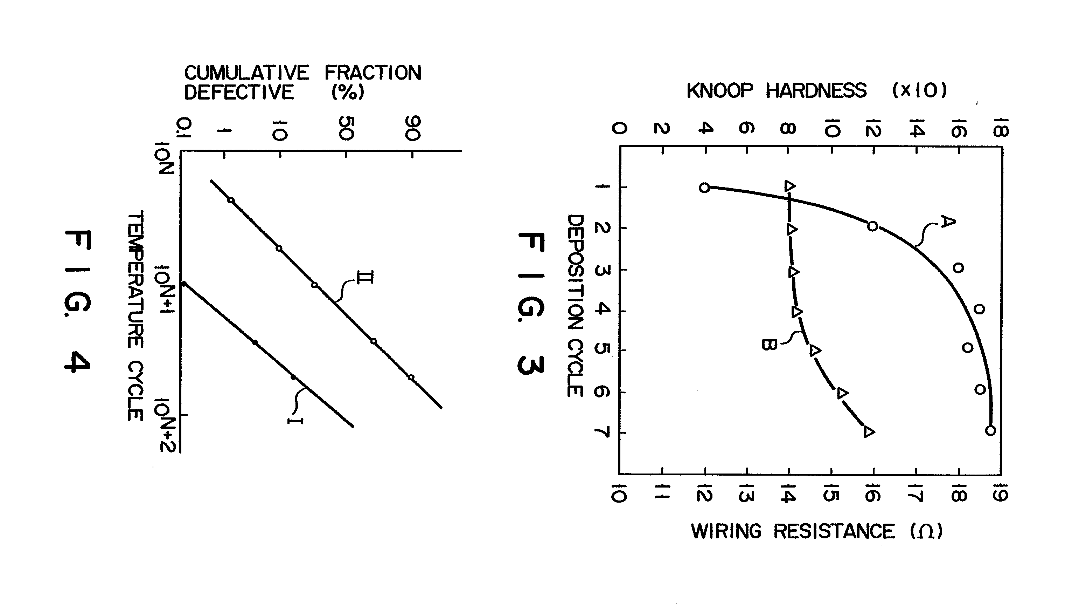

Upon repetition of steps S2 to S5, an aluminum film having a thickness of 1.0 $\mu$m was formed and patterned to finally form a wiring having a width of 2 $\mu$m and a length of 1.0 mm. In this case, the number of cycles for repeating steps S2 to S5 was changed, and it was checked how the hardness of the resultant aluminum films was changed. In addition, it was checked how the resistance of the resultant wirings was changed. Fig. 3 shows the result. Curve A in Fig. 3 represents changes in Knoop hardness of the aluminum wirings, and curve B represents changes in resistance of the aluminum wirings. As is apparent from the result, the film hardness is greatly increased in proportion to the number of cycles for repeating steps S2 to S5, i.e., the number of depositing aluminum films. Furthermore, since the number of alumina layers interposed between the aluminum thin films is increased as the number of deposition cycles is increased, the resistance of the aluminum wiring is also increased in proportion to the number of deposition cycles. However, the resistance thus increased falls within the range of practical applications. Note that the final film thickness was increased to 2.0 $\mu$m and the same test was performed. However, it was found that the resistance was not further increased.

In addition, chips, each of which had a size of 7 mm $\times$ 7 mm were prepared. An aluminum wiring had been formed on each chip by repeating the deposition process three times. Then, the chips were resin-sealed to perform a thermal history test. According to the test, 1 cycle was constituted by an operation time of 30 minutes at -55°C, an operation time of 5 minutes at 25°C, and an operation time of 30 minutes at 150°C. This cycle was repeated a predetermined number of times so as to make an evaluation on the basis of cumulative defection rate (%) of the wirings. For comparison, the same test was performed using chips on which aluminum wirings were formed by the conventional method, i.e., in one deposition process. Curves I and II in Fig. 4 show the results of the embodiment and the conventional method, respectively. As is apparent from these results, the frequency of failures in Example is greatly reduced compared with that in the conventional method.

In addition, failures due to electromigration were checked for semiconductor devices according to both the method of Example and conventional method. It was found that the mean time to failure (MTF) of the devices according to Example were about twice the devices of the conventional method. Accordingly, in Example, grains in the aluminum wiring were decreased in size so that electromigration was not easily caused, thereby improving reliability. This tendency became conspicuous as the size of wiring was decreased.

## Claims

1. A method of forming an aluminum wiring in a semiconductor device, in which a wiring material layer having a desired film thickness is deposited on said semiconductor substrate and patterned to a desired shape, characterized in that

the step of depositing said wiring material layer is performed by continually and alternately repeating the first step of depositing a thin film of aluminum or an aluminum alloy on said semiconductor substrate, and the second step of covering said thin film of aluminum or an aluminum alloy with an oxide film by oxidizing the surface of the thin film.

2. A method according to claim 1, characterized in that the step of oxidizing the surface of said thin film of aluminum or an aluminum alloy is performed by keeping said thin film of aluminum or an aluminum alloy exposed to the air.

3. A method according to claim 1, characterized in that the step of oxidizing the surface of said thin film of aluminum or an aluminum alloy is performed by keeping said thin film of aluminum or an aluminum alloy exposed to the air while heating said thin film.

4. A method according to claim 1, characterized in that the step of oxidizing the surface of said thin film of aluminum or an aluminum alloy is performed by soaking said thin film of aluminum or an aluminum alloy in pure water.

F I G. IA

F I G. IB

F I G. 2

F I G. 3

F I G. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENT ABSTRACTS OF JAPAN, vol. 6, no. 147 (E-123)[1025], 6th August 1982; JP-A-57 71 131 (MITSUBISHI DENKI K.K.) 01-05-1982 * Abstract * | 1,2 | H 01 L 21/31 H 01 L 23/52 H 01 L 21/90 |
| A | JOURNAL OF VACUUM SCIENCE & TECHNOLOGY/B, vol. 3, no. 3, second series, May-June 1985, pages 923-924, American Vacuum Society, Woodbury, New York, US; A. SINGH: "A simple technique for eliminating hillocks in integrated circuit metallization" * Whole article , especially the abstract * | 4 | |
| A | US-A-4 302 498 (T.J. FAITH, Jr.) * Abstract; figure 2; column 4, line 61 - column 6, line 37; esp. column 6, lines 24-32 * | 1 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 24-06-1988 | MACHEK,J. |